# EUROPEAN PATENT SPECIFICATION

(11) **EP 0 774 178 B1**
(45) Date of publication and mention of the grant of the patent: **14.03.2001**
(21) Application number: 96913665.4
(22) Date of filing: 23.05.1996
(51) Int. Cl.: H03K 5/153

(54) **DETECTION CIRCUIT WITH HYSTERESIS PROPORTIONAL TO THE PEAK INPUT VOLTAGE**
DETEKTORSCHALTUNG MIT ZUR EINGANGSSPITZENSPANNUNG PROPORTIONALER HYSTERESE
CIRCUIT DE DETECTION A HYSTERESIS PROPORTIONNELLE A LA TENSION DE CRETE EN ENTREE

(30) Priority: 07.06.1995 US 488540
(43) Date of publication of application: 21.05.1997
(73) Proprietor: Koninklijke Philips Electronics N.V., 5621 BA Eindhoven (NL)
(72) Inventor: FONDERIE, Maarten, J., 5656 AA Eindhoven (NL); HUIJSING, Johan, Hendrik, NL-2626 HD Schipluiden (NL); TOY, Edmond, Sunnyvale, CA 94087 (US)
(74) Representative: Hesselmann, Gerardus Johannes Maria
(86) International application number: PCT/IB96/00486
(87) International publication number: WO 96/41415

(56) References cited:
- EP-A- 0 366 619
- EP-A- 0 529 710
- US-A- 3 617 904
- US-A- 3 767 938
- US-A- 3 944 936
- US-A- 5 019 722
- PATENT ABSTRACTS OF JAPAN vol. 9, no. 136 (E-320) 12 June 1985 & JP 60 020 641 A (MATSUSHITA DENKI SANGYO KK) 01 February 1985

## Description

The present invention relates to detection circuits. More particularly, it relates to a detection circuit comprising:
a voltage-to-current converter for converting an input voltage to be detected to a current signal;
diode means coupled to receive the current signal from the voltage-to-current converter for generating a log voltage signal across the diode means;
a first comparator for comparing the log voltage signal with a reference voltage and for producing a first comparison signal. Such a detection circuit is known from Patent Abstracts of Japan, vol.9, no.136 (E-320), 12 June 1985, JP 60 020 641 A and can be used for detecting input voltages that range from a few hundred milli-volts to a few hundred volts. The input voltage is converted into an input current by the voltage-to-current converter implemented with a resistor in series with the input voltage. The output current of the voltage-to-current converter generates a log voltage across the diode means. The first comparator measures the zero crossings in the voltage at the diode means.

In the automotive field, variable reluctance sensors (VRS) are used for detecting the position of the pistons and for measuring the rotation speed of the driveshaft. The VRS consists of an inductive sensor and a toothed wheel that is rotated by the engine. Thus, the signal amplitude from the VRS depends on the rotation speed of the toothed wheel, and can vary from a few hundred millivolts to several hundred volts. Due to the harsh automotive environment, considerable interference is added to this signal. As a result, a comparator circuit with a fixed hysteresis level is not capable of accurately detecting the VRS signal.

U.S. Patent No. 4,117,757 discloses a rectangular waveform signal reproducing circuit for electronic musical instruments which reproduces a rectangular waveform from a monophonic signal having the same fundamental period thereof. The circuit comprises comparators having one input directly coupled to an input signal and the other input to a peak detector which receives the same input signal. The outputs of the comparators drive set and reset inputs of a flip-flop.

U.S. Patent No. 3,767,938 discloses a zero sense after peak detection circuit. The circuit provided is a discriminator circuit capable of storing a rejection level which is a predetermined percentage of a valid input signal. The circuit comprises a comparator in parallel with a peak detector. The outputs of the comparator and the peak detector drive set and reset inputs of a flip-flop. Upon exceeding the stored rejection level by a succeeding input signal, an indicator is reset by the input signal whereby a zero crossing detection circuit sets the indicators as the input signal passes through zero volts. A noise signal never exceeds the predetermined rejection level and thus the indicator is not reset.

It is an object of the present invention to provide an accurate detection circuit capable of handling a wide range of input voltages.

The present invention provides a detection circuit which is characterized in that the detection circuit further comprises:
peak detector means for sensing the log voltage signal across said diode means and for generating a peak voltage signal proportional to the peak value of the log voltage signal;
a second comparator having inputs coupled to receive the peak voltage signal and the log voltage signal for comparing the peak voltage signal with the log voltage signal and for producing a second comparison signal;
offset means for providing an offset voltage to one of the inputs of the second comparator; and
a flip-flop having set and reset inputs for receiving the first comparison signal and the second comparison signal and an output for producing an output signal.

In this way a hysteresis proportional to the peak value of the input signal is obtained that is a fixed ratio of the peak value of the input voltage over a wide input voltage range. The offset voltage may be temperature dependent in order to match the temperature dependency of the diode means. For this purpose the offset means may comprise a bipolar differential transistor pair with scaled transistors, the bases of the transistor pair forming the inputs of the second comparator. By scaling the size of the differential pair transistors a systematic offset voltage is created with the same temperature characteristics as the log voltage across the diode means. Further advantageous embodiments of the invention are specified in the dependent claims.

Other objects and features of the present invention will become apparent from the following detailed description considered in connection with the accompanying drawings which disclose several embodiments of the present invention. It should be understood, however, that the drawings are designed for the purpose of illustration only and not as a definition of the limits of the invention.

In the drawings, wherein similar reference characters denote similar elements throughout the several views:
FIG. 1 is a block diagram of a logarithmic compression circuit of the prior art;
FIG. 2 is a block diagram of an embodiment of a detection circuit according to the invention;
FIG. 3 is a graphical representation of the desired output waveform generated by the circuit of FIG. 2;
FIG. 4 is a schematic diagram of the differential voltage-to-current converter and current amplifier of the circuit shown in FIG. 2;
FIG. 5 is a schematic diagram of a peak detector and a comparator for use in a detection circuit according to the invention;
FIG. 6 is a block diagram of an embodiment of a detection circuit according to the invention;
FIG. 7 is a block diagram of an embodiment of a detection circuit according to the invention;
FIG. 8 is a block diagram of an embodiment of a detection circuit according to the invention;
FIG. 9 is a schematic diagram of a peak detector and a comparator for use in a detection circuit according to the invention; and
FIG. 10 is a schematic diagram of an embodiment of a detection circuit 2 according to the invention.

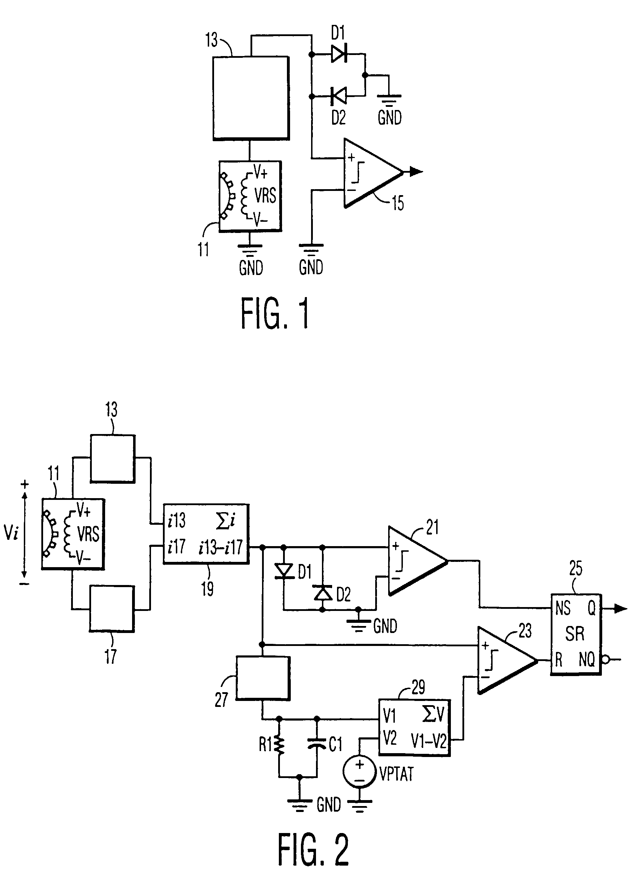

FIG. 1 shows a well-known example of logarithmic compression of an input signal, using bipolar diodes as converting elements. The input signal is provided by a VRS (variable reluctance sensor) 11, but the principle is valid for any input signal source. The input voltage is converted into an input current by the voltage-to-current (VI) converter block 13. The output current of VI converter 13 generates a log voltage when connected to diodes D1 and D2 as a result of the logarithmic relationship between the voltage across and the current through the diodes. The comparator 15 measures the zero crossings in the voltage at the diodes.

Diodes D1 and D2, comparator 15 and sometimes VI converter 13 can be implemented in an integrated circuit. This is however, not essential to the operation of the circuit. The circuit of FIG. 1 is capable of handling a large dynamic range of the input signal, but no hysteresis is applied to the signal. Hysteresis helps to improve the rejection of undesired noise added to the input signal. The absolute value of these noise disturbances can be proportional to the value of the actual input signal. Therefore, a hysteresis that is proportional to the peak value of the input signal is desired.

Furthermore, the known VI converter shown in FIG. 1 is a single-ended circuit, so that one side of VRS 11 needs to be grounded. Thus, the circuit is sensitive to differences between the ground potential of sensor 11 and that of diodes Dl and D2. In addition, an unintentional short circuit of the sensor output to ground will cause a malfunction of the system. Embodiments of the circuit of the present invention overcome these drawbacks.

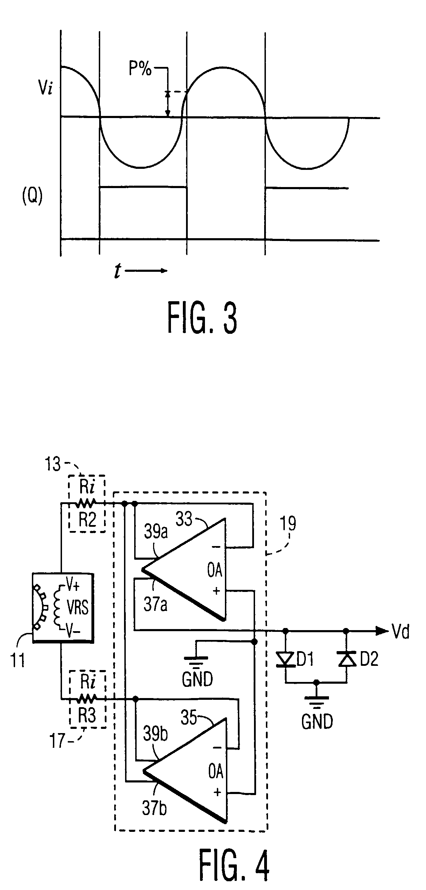

The circuit of FIG. 2 shows an embodiment of the present invention. The VRS 11 is now followed by differential voltage-to-current converters 13 and 17, and a differential current amplifier 19. The output current from differential current amplifier 19 generates the log voltage over the diodes D1 and D2, and the zero crossings in this log voltage signal are measured by comparator 21. In parallel to this path, a comparator 23 senses the log voltage and compares it to a voltage, generated by a peak detector 27, that is proportional to the peak value of the log voltage signal. The two comparators 21 and 23 drive a set-reset (SR) flip-flop 25 to generate the desired digital output waveform Vₒᵤₜ, shown in FIG. 3. The output voltage Vₒᵤₜ is inverted relative to the input voltage Vi of VRS 11, although a non-inverting output is also available. The output voltage Vₒᵤₜ changes polarity at the negative-swing zero crossings of the input voltage Vi. For the positive-swing zero crossings, a hysteresis equal to a fraction or percentage p of the peak value takes place. In practice, p has a value of 10% to 40%. The principle can be modified to show this hysteresis at either the negative-swing zero crossing, or at both the positive and negative-swing zero crossings.

In FIG. 4 shows a detail circuit of VRS 11, the VI converters 13 and 17, and differential current amplifier 19 of FIG. 2. The VI converters 13 and 12 consist of two external resistors R2 and R3, respectively, which are only necessary if the voltages from the VRS sensor greatly exceed the breakdown voltages of the components. The operational amplifiers (opamps) 33 and 35 each have two identical outputs, 39a-37a and 39b-37b, respectively. Thus, the current flowing into or out of outputs 37a and 37b is identical to the current going in or out of outputs 39a and 39b, respectively. Output 39a is connected to the inverting input of opamp 33 and to resistor R2. Output 39b of opamp 35 is connected to the inverting input of opamp 35 and to resistor R3. Output 37a of opamp 33 is connected to the diodes Dl and D2. Output 37a of opamp 35 is connected to output 39a of opamp 33. The non-inverting inputs of opamps 33 and 35 are connected to the same reference (ground) as the diodes D1 and D2. The opamp side of the resistors R2 and R3 is kept at ground potential by the feedback loop around the opamps 33 and 35. With Rᵢ equal to the value of the resistors R2 and R3, the current i- flowing through resistor R3 is:$\text{i -} \text{=} \frac{\text{V} \text{-}}{{\text{R}}_{\text{i}}}$ where V- is the voltage on the negative pin of VRS 11.

Similarly, the current i+ through resistor R2 is:$\text{i} \text{+ =} \frac{\text{V} \text{+}}{{\text{R}}_{\text{i}}}$

Because the currents through both outputs of the opamps are identical, the current I_{d} through the diodes D1, D2 is equal to the difference of i+ and i-:${\text{I}}_{\text{d}} \text{=} \frac{\text{V} \text{+-} \text{V} \text{-}}{{\text{R}}_{\text{i}}} \text{=} \frac{{\text{V}}_{\text{i}}}{{\text{R}}_{\text{i}}}$ where Vᵢ is the voltage over the VRS 11. With Iₛ equal to the saturation current of the diodes D1, D2 and VT the thermal voltage (VT=kT/q), the voltage V_{d} over the diodes is:${\text{V}}_{\text{d}} \text{=} \text{VT} \text{∗} \text{ln} \text{(} \frac{{\text{I}}_{\text{d}}}{{\text{I}}_{\text{s}}} \text{) =} \text{VT∗ln} \text{(} \frac{{\text{V}}_{\text{i}}}{{\text{R}}_{\text{i}} {\text{∗I}}_{\text{s}}} \text{)}$ By using logarithmic current to voltage conversion, the compression that is needed to handle the large dynamic voltage range is achieved. Comparator 21 detects the negative-swing zero crossing of input voltage Vᵢ by measuring the voltage V_{d}. This sets flip-flop 25 and forces the output voltage Vₒᵤₜ of the detection circuit to go high.

Due to the differential design of the voltage-to-current converter, (unintentionally) grounding either terminal of VRS 11 does not change this result. For the circuit to operate properly, the opamps 33 and 35 need to operate within the large dynamic range of the input signal. Thus, they have to accurately handle both large and small currents and, therefore, the output stages of the opamps 33 and 35 may require a class-AB current control.

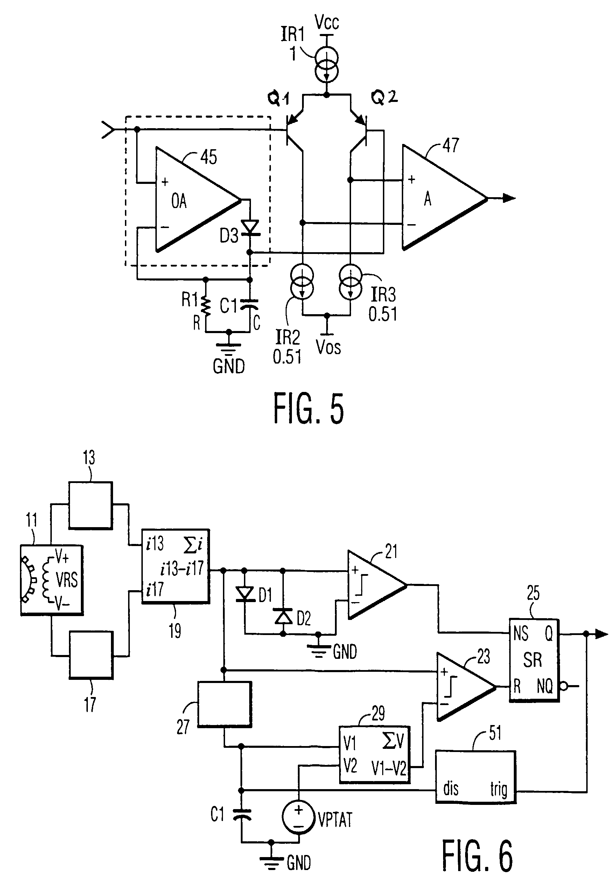

FIG. 5 shows an implementation of the peak detector 27. The output of an opamp 45 is loaded with a series arrangement of a diode D3 and a hold capacitor Cl. The capacitor C1 is shunted by a resistor R1. The inverting input of the opamp 45 is connected to the interconnection node of diode D3 and capacitor C1. The non-inverting input of opamp 45 receives the log voltage signal. The maximum voltage over the logarithmic diodes Dl and D2 is stored on the capacitor C1 of the peak detector, and it decays at the rate set by the RC-time of the filter consisting of the hold capacitor Cl and resistor R1. The right-hand portion of FIG. 5 shows a comparator consisting of a differential input pair with scaled input transistors Q1 and Q2, followed by an amplifier gain stage 47. Due to the scaling of transistors Q1 and Q2, this comparator has a systematic input offset voltage equal to:${\text{V}}_{\text{os}} \text{=} \text{VT∗ln} \text{(} \text{n} \text{)}$ where n is the scaling factor of the transistors Q1 and Q2.

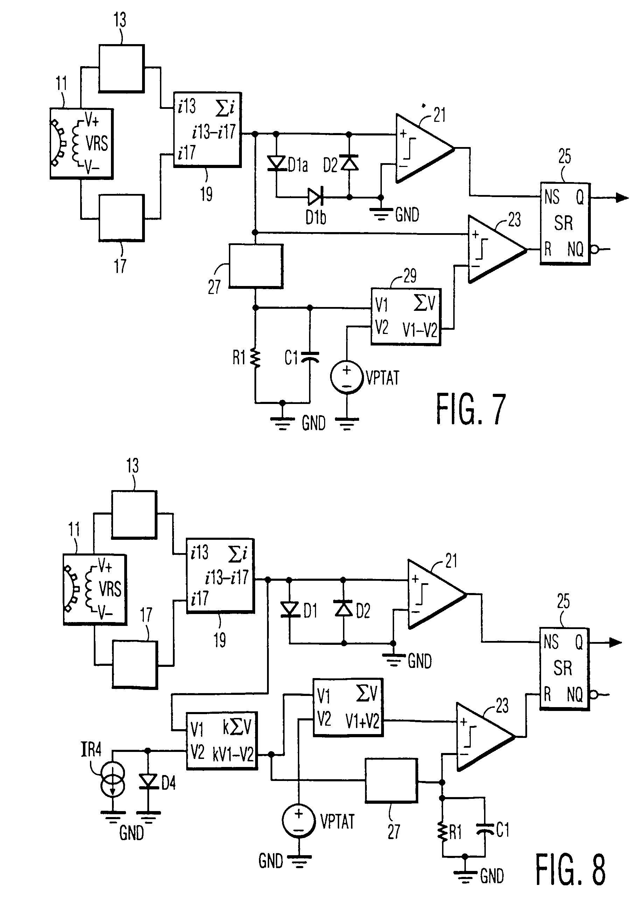

This offset voltage is represented as a source VPTAT (voltage proportional to absolute temperature), the voltage of which is added or subtracted to one of the inputs of comparator 23 by means of a block 29 in Figs. 2, 6, and 7 and a block 57 in Fig. 8. So, the scaled differential pair Q1/Q2 and gain stage 47 in Fig. 5 correspond functionally to source VPTAT, block 29 and comparator 23 in Fig. 2.

The output voltage V_{comp} of gain stage 47 changes when:${\text{V}}_{\text{d}} \text{=} {\text{V}}_{\text{dmax}} {\text{-V}}_{\text{os}}$ where V_{dmax} is the maximum voltage on the diodes D1 and D2, as it is stored on capacitor C1 by the peak detector 27. If Vᵢ1 is the value of the input voltage for which the output of comparator 23 switches polarity, and Vᵢₘₐₓ is the maximum value of the input voltage, corresponding to V_{dmax}, substituting (4) and (5) into (6) yields:$\text{VT∗} \text{ln (} \frac{{\text{V}}_{\text{i}} \text{1}}{{\text{R}}_{\text{i}} {\text{∗I}}_{\text{s}}} \text{) =} \text{VT∗ln} \text{(} \frac{{\text{V}}_{\text{imax}}}{{\text{R}}_{\text{i}} {\text{∗I}}_{\text{s}}} \text{)} \text{-VT∗ln} \text{(} \text{n} \text{)}$ or:${\text{V}}_{\text{i}} \text{1} \text{=} \frac{\text{1}}{\text{n}} {\text{∗V}}_{\text{imax}}$

The second comparator 21, shown in FIG. 2, switches when the VRS input voltage Vᵢ2 has a value of zero. If 1/n is chosen equal to the fraction or percentage p, shown in FIG. 3, the hysteresis voltage can be written as:${\text{V}}_{\text{hys}} \text{=} {\text{V}}_{\text{i}} {\text{1-V}}_{\text{i}} \text{2} \text{=} \frac{\text{1}}{\text{n}} {\text{∗V}}_{\text{imax}} \text{=} {\text{p∗V}}_{\text{imax}}$

The SR flip-flop 25 is set at the negative swing zero crossing of the VRS voltage, and it is reset when the VRS voltage becomes greater than a fraction or percentage p of its maximum value.

FIG. 6 shows a modified variation of the detection circuit as shown in FIG. 2. Resistor R1 is replaced with a discharge block 51 which discharges the capacitor Cl in response to the output voltage Vₒᵤₜ of flip-flop 25. This has the advantage that a smaller (on-chip) capacitor Cl can be used. For successful operation, the input currents to the blocks that are connected to the capacitor C1 should be small. Thus, this circuit is especially suited for implementation in a BiCMOS process. If CMOS input transistors are used in voltage subtracter block 29, connected to capacitor C1, the voltage on the capacitor Cl ideally does not change during the comparison cycle and, therefore, more accurate measurements can be obtained.

A second variation to the embodiment of FIG. 2 is shown in FIG. 7. Diode Dl of FIG. 2 has been replaced by diodes D1a and D1b in series, as shown. In this configuration, the voltage signals on the diodes D1a and Dlb and on the peak capacitor Cl are doubled. Thus, if the capacitor C1 is connected to an external ground, having two diodes D1a and D1b instead of just one, makes the circuit less sensitive to differences between the internal and external ground. To maintain a hysteresis of p=1/n, the PTAT voltage (i.e., the voltage proportional to absolute temperature) of VPTAT also needs to be twice as large. In the implementation shown in FIG. 5, this translates to an area scaling of the comparator input transistors Q1 and Q2 of n².

To decrease the circuit's sensitivity to ground differences even further, three or four diodes could be stacked in series. However, depending on the value of the supply voltage of the circuit, this approach may become impractical.

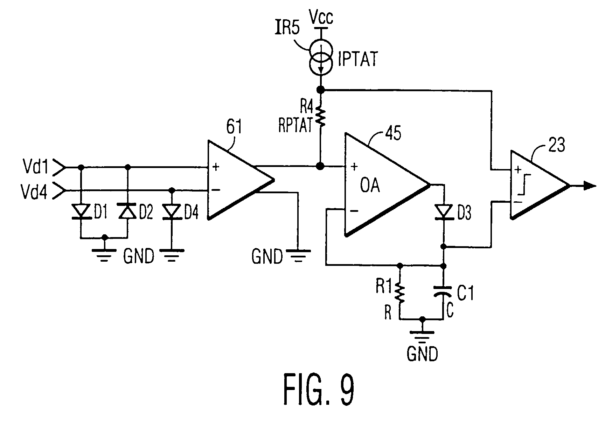

The circuit shown in FIG. 8 overcomes this problem by using a differential amplifier 55 to sense the difference between the voltage on the log voltage diode Dl and that on a reference diode D4 which receives a bias current from reference current source IR4. Only this difference, multiplied by the differential amplifier gain k, is used and its peak value is stored on the capacitor Cl. The resultant signal on the capacitor Cl is comparable to that of k diodes in series. If the scaling of the comparator input transistors is again used to obtain the PTAT voltage, the scaling factor must be n^{k}. For large values of k, this factor may be impractically large, so a different approach to obtain the PTAT voltage difference at the input of comparator 23 is shown in FIG. 9. A PTAT current source IR5 generates a voltage difference over resistor R4. The PTAT voltage is then added to the positive input voltage of comparator 23, rather than subtracted from the negative input voltage, and thus allows the PTAT current to flow into the low impedance output of differential amplifier 61 which senses the difference between the voltage on the diode Dl and the reference diode D4.

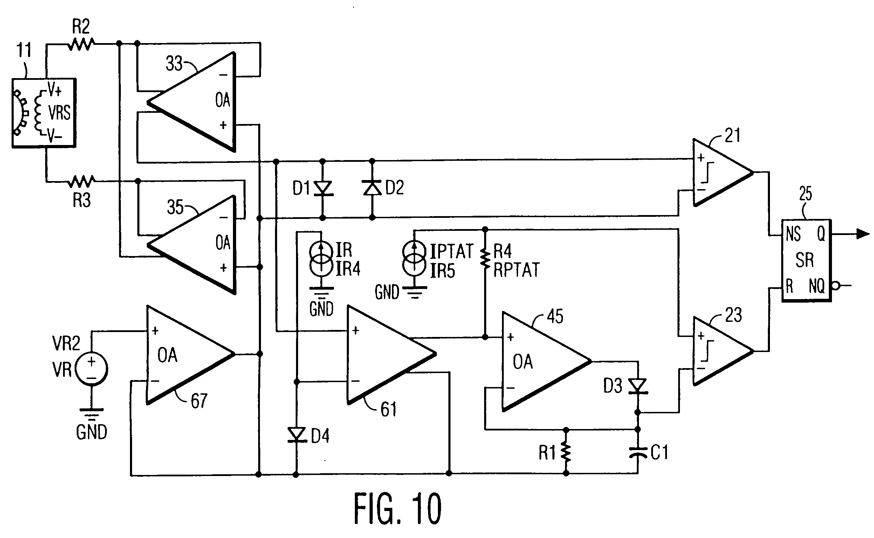

In FIG. 10 the circuits of FIG. 4 and FIG. 9 are combined to provide an embodiment of the DCPH with a differential amplifier. A voltage follower opamp 67 generates an internal reference voltage VR. This enables the detection circuit to operate from a single sided supply voltage, rather than from a symmetrical supply. The output voltage of differential amplifier 61 is given by:${\text{V}}_{\text{dif}} \text{=(} {\text{V}}_{\text{dif}} \text{+)-(} {\text{V}}_{\text{dif}} \text{-)=} \text{k∗VT∗ln} \text{(} \frac{{\text{V}}_{\text{i}}}{{\text{R}}_{\text{i}} \text{∗IR}} \text{)}$ where IR is the reference current through diode D4, and k is the gain of the differential amplifier 61. The PTAT current IPTAT of IR5 can be written as:$\text{IPTAT} \text{=} \frac{\text{VT}}{\text{Rp}} \text{∗ln} \text{(} \text{m} \text{)}$ where Rp and m are parameters of the PTAT current source implementation. Rp is a resistor value and m is a scaling factor of two of the transistors of the PTAT current source. The output voltage of comparator 23 changes when:${\text{V}}_{\text{dif}} \text{+} \text{IPTAT∗RPTAT} \text{=} {\text{V}}_{\text{difmax}}$ where V_{difmax} is the voltage stored on capacitor C1, which is equal to the maximum output voltage of differential amplifier 61, corresponding to the maximum input voltage Vᵢₘₐₓ from VRS 11. If Vᵢ1 equals the value of the input voltage for which the output of comparator 23 switches polarity, substitution of (10) and (11) into (12) yields:${\text{V}}_{\text{i}} \text{1=} \frac{\text{1}}{\text{m} {\text{}}^{\text{(} \frac{\text{Rp}}{\text{RPTAT∗k}} \text{)}}} {\text{∗V}}_{\text{imax}}$

The input voltage Vᵢ2 for which the second comparator 21, shown in FIG. 10, again switches polarity has a value of 0V. If the first factor of the right-hand side of equation (13) is chosen equal to the fraction or percentage p, the hysteresis can now be written as:${\text{V}}_{\text{hys}} \text{=} {\text{V}}_{\text{i}} \text{1-} {\text{V}}_{\text{i}} \text{2=} \frac{\text{1}}{{\text{}}_{\text{m}} \text{(} {\text{}}_{\frac{\text{Rp}}{\text{RPTAT∗k}}} \text{)}} {\text{∗V}}_{\text{imax}} {\text{=p∗V}}_{\text{imax}}$

If, for instance, the resistor ratio RPTAT/Rₚ is chosen equal to the differential amplifier gain k, which is also set by a resistor ratio, then the hysteresis percentage p is equal to the PTAT scaling factor m. The hysteresis is, therefore, a well-controlled parameter.

In practice, for small values of the input voltage Vᵢ, the amplitude of the signal noise disturbances is no longer proportional to Vᵢ, but rather has a constant value. For these small input signals, the hysteresis preferably has a minimum value, rather than being equal to a percentage of the peak value. The circuit of FIG. 10 supplies a solution to this problem. The voltage on capacitor C1 rises only if the current through diode D1 is larger than the reference current IR through diode D4. For currents through diode D1 less than the value IR, the voltage on capacitor C1 is zero and the negative input of comparator 23 remains at the value of VR, the internal reference voltage. For these small input voltages, when the voltage on Cl is zero, the output of comparator 23 switches polarity when:${\text{V}}_{\text{dif}} \text{+} \text{IPTAT∗RPTAT} \text{=0}$ and the input voltage is equal to${\text{V}}_{\text{i}} \text{1 =} \frac{\text{1}}{\text{m} {\text{}}^{\text{(} \frac{\text{Rp}}{\text{RPTAT∗k}} \text{)}}} \text{∗IR∗Ri}$

Comparator 21 continues switching polarity when the input voltage Vᵢ2 is zero, and therefore, the minimum value of the hysteresis is equal to:$\text{V} {\text{}}_{{\text{hys}}_{\text{min}}} \text{=} {\text{V}}_{\text{i}} \text{1-} {\text{V}}_{\text{i}} \text{2=} \frac{\text{1}}{\text{m} {\text{}}^{\text{(} \frac{\text{Rp}}{\text{RPTAT∗k}} \text{)}}} \text{∗IR∗Ri} \text{=} \text{p∗IR∗Ri}$

Further modifications of the circuit that are possible include scaling of the input and reference diodes, connecting the RC-time filter C1/R1 to an external, instead of an internal ground.

## Claims

1. A detection circuit comprising:
a voltage-to-current converter (13) for converting an input voltage to be detected to a current signal;
diode means (D1, D2) coupled to receive the current signal from the voltage-to-current converter (13) for generating a log voltage signal across the diode means (Dl, D2);
a first comparator (21) for comparing the log voltage signal with a reference voltage and for producing a first comparison signal, characterized in that the detection circuit further comprises:
peak detector means (27) for sensing the log voltage signal across said diode means (D1, D2) and for generating a peak voltage signal proportional to the peak value of the log voltage signal;
a second comparator (23) having inputs coupled to receive the peak voltage signal and the log voltage signal for comparing the peak voltage signal with the log voltage signal and for producing a second comparison signal;
offset means (29) for providing an offset voltage to one of the inputs of the second comparator (23); and
a flip-flop (25) having set and reset inputs for receiving the first comparison signal and the second comparison signal and an output for producing an output signal.

2. The detection circuit according to claim 1, wherein the offset voltage produced by the offset means comprises a voltage component which is proportional to absolute temperature.

3. The detection circuit according to claim 2, wherein the offset means comprises a bipolar differential transistor (Q1, Q2) pair with scaled transistors, the bases of the transistor pair (Q1, Q2) forming the inputs of the second comparator (23).

4. The detection circuit according to claim 1, 2 or 3, wherein the peak detector means (27) comprises a capacitor (Cl) for holding the peak voltage signal and means (51) for discharging the holding capacitor (C1) in response to the output signal of the flip-flop.

5. The detection circuit according to claim 1, 2, 3 or 4, wherein the diode means comprises at least two equally directed diodes (D1a, D1b) connected in series with each other and a further oppositely directed diode (D2) disposed parallel with respect to said at least two equally directed diodes (D1a, D1b).

6. The detection circuit according to claim 1, 2, 3, 4 or 5, further comprising:
a reference current source (IR4) for supplying a reference current;
a reference diode (D4) coupled to receive the reference current from the reference current source (IR4) for generating a reference voltage signal across the reference diode (D4); and
means (55, 61) for subtracting the reference voltage signal from the log voltage signal.

7. The detection circuit according to claim 6, further comprising a resistor (R4) and a temperature dependent current source (IR5) for supplying a current proportional to absolute temperature through the resistor (R4), the voltage across the resistor (R4) being coupled to one of the inputs of the second comparator (23).

8. The detection circuit according to claim 7, wherein the resistor (R4) is connected between the temperature dependent current source (IR5) and an output of the means (61) for subtracting.

9. The detection circuit according to claim 1, 2, 3, 4, 5, 6, 7 or 8, wherein the voltage-to-current converter (13) is a differential voltage-to-current converter (13, 17, 19) having a differential input for receiving the input voltage.

10. The detection circuit according to claim 9, wherein the differential voltage-to-current converter (13, 17, 19) comprises:
a first conversion resistor (R2) and a second conversion resistor (R3);
a first amplifier (33) having an inverting input, a non-inverting input and two outputs (39a, 37a) substantially equally responsive to a voltage difference between the inverting and non-inverting inputs of the first amplifier, one (39a) of the two outputs of the first amplifier (33) being coupled to the inverting input of the first amplifier (33) and to the first conversion resistor (R2), the other (37a) of the two outputs of the first amplifier (33) being coupled to the diode means (D1, D2);
a second amplifier (35) having an inverting input, a non-inverting input and two outputs (39b, 37b) substantially equally responsive to a voltage difference between the inverting and non-inverting inputs of the second amplifier (35), one (39b) of the two outputs of the second amplifier (35) being coupled to the inverting input of the second amplifier (35) and to the second conversion resistor (R3), the other (37b) of the two outputs of the second amplifier (35) being coupled to said one output (39a) of the first amplifier (33) which is coupled to the inverting input of the first amplifier (33).

## Patentansprüche

1. Detektionsschaltung mit:
einem Spannung-Strom-Wandler (13) zum Umwandeln einer zu detektierenden Eingangs-spannung in ein Stromsignal;
Diodenmitteln (D1, D2), die zum Empfangen des Stromsignals aus dem Spannung-Strom-Wandler (13) geschaltet sind, um ein log-Spannungssignal am Diodenmittel (D1, D2) zu generieren;
einem ersten Komparator (21) zum Vergleichen des log-Spannungssignals mit einer Bezugsspannung und zum Erzeugen eines ersten Vergleichssignals, dadurch gekennzeichnet, dass die Detektionsschaltung weiterhin umfasst:
Spitzendetektormittel (27) zum Detektieren des log-Spannungssignals an dem genannten Diodenmittel (D1, D2) und zum Generieren eines Spitzenspannungssignals proportional zum Spitzenwert des log-Spannungssignals;
einen zweiten Komparator (23) mit Eingängen, die zum Empfangen des Spitzenspannungssignals und des log-Spannungssignals geschaltet sind, um das Spitzen-spannungssignal mit dem log-Spannungssignal zu vergleichen und ein zweites Vergleichs-signal zu erzeugen;
Offsetmittel (29) zum Liefern einer Offsetspannung an einen der Eingänge des zweiten Komparators (23); und
einen Flipflop (25) mit Setz- und Rücksetzeingängen zum Empfangen des ersten Vergleichssignals und des zweiten Vergleichssignals und einem Ausgang zum Erzeugen eines Ausgangssignals.

2. Detektionsschaltung nach Anspruch 1, wobei die von dem Offsetmittel erzeugte Offsetspannung eine Spannungskomponente umfasst, die proportional zur absoluten Temperatur ist.

3. Detektionsschaltung nach Anspruch 2, wobei das Offsetmittel ein Paar bi-polarer differentieller Transistoren (Q1, Q2) mit skalierten Transistoren umfasst, wobei die Basen des Transistorpaares (Q1, Q2) die Eingänge des zweiten Komparators (23) bilden.

4. Detektionsschaltung nach Anspruch 1, 2 oder 3, wobei das Spitzendetektormittel (27) einen Kondensator (C1) zum Halten des Spitzenspannungssignals umfasst und Mittel (51) zum Entladen des Haltekondensators (Cl) in Reaktion auf das Ausgangssignal des Flipflops.

5. Detektionsschaltung nach Anspruch 1, 2, 3 oder 4, wobei das Diodenmittel zumindest zwei gleich gerichtete Dioden (D1a, D1b) umfasst, die zueinander in Reihe geschaltet sind, und eine weitere entgegengesetzt gerichtete Diode (D2), die in Bezug auf die genannten zumindest zwei gleich gerichteten Dioden (D1a, D1b) parallel geschaltet ist.

6. Detektionsschaltung nach Anspruch 1, 2, 3, 4 oder 5, weiterhin mit:
einer Bezugsstromquelle (IR4) zum Liefern eines Bezugsstroms;
einer zum Empfangen des Bezugsstroms aus der Bezugsstromquelle (IR4) geschalteten Bezugsdiode (D4) zum Generieren eines Bezugsspannungssignals an der Bezugsdiode (D4); und
Mitteln (55, 61) zum Subtrahieren des Bezugsspannungssignals vom log-Spannungssignal.

7. Detektionsschaltung nach Anspruch 6, mit weiterhin einem Widerstand (R4) und einer temperaturabhängigen Stromquelle (IR5) zum Liefern eines Stroms proportional zur absoluten Temperatur durch den Widerstand (R4), wobei die Spannung am Widerstand (R4) mit einem der Eingänge des zweiten Komparators (23) gekoppelt ist.

8. Detektionsschaltung nach Anspruch 7, wobei der Widerstand (R4) zwischen die temperaturabhängige Stromquelle (IR5) und einen Ausgang des Mittels (61) zum Subtrahieren geschaltet ist.

9. Detektionsschaltung nach Anspruch 1, 2, 3, 4, 5, 6, 7 oder 8, wobei der Spannung-Strom-Wandler (13) ein differentieller Spannung-Strom-Wandler (13, 17, 19) mit einem Differenzeingang zum Empfangen der Eingangsspannung ist.

10. Detektionsschaltung nach Anspruch 9, wobei der differentielle Spannung-Strom-Wandler (13, 17, 19) umfasst:
einen ersten Konversionswiderstand (R2) und einen zweiten Konversionswiderstand (R3);
einen ersten Verstärker (33) mit einem invertierenden Eingang, einem nichtinvertierenden Eingang und zwei Ausgängen (39a, 37a), die nahezu gleich auf eine Spannungsdifferenz zwischen den invertierenden und nichtinvertierenden Eingängen des ersten Verstärkers ansprechen, wobei einer (39a) der beiden Ausgänge des ersten Verstärkers (33) mit dem invertierenden Eingang des ersten Verstärkers (33) und dem ersten Konversionswiderstand (R2) gekoppelt ist, der andere (37a) der beiden Ausgänge des ersten Verstärkers (33) mit dem Diodenmittel (D1, D2) gekoppelt ist;
einen zweiten Verstärker (35) mit einem invertierenden Eingang, einem nichtinvertierenden Eingang und zwei Ausgängen (39b, 37b), die nahezu gleich auf eine Spannungsdifferenz zwischen den invertierenden und nichtinvertierenden Eingängen des zweiten Verstärkers (35) ansprechen, wobei einer (39b) der beiden Ausgänge des zweiten Verstärkers (35) mit dem invertierenden Eingang des zweiten Verstärkers (35) und dem zweiten Konversionswiderstand (R3) gekoppelt ist, der andere (37b) der beiden Ausgänge des zweiten Verstärkers (35) mit dem genanten einen Ausgang (39a) des ersten Verstärkern (33) gekoppelt ist, der mit dem invertierenden Eingang des ersten Verstärkers (33) gekoppelt ist.

## Revendications

1. Circuit de détection comprenant:
un convertisseur tension-courant (13) pour convertir une tension d'entrée à détecter en un signal de courant;
des moyens à diodes (Dl, D2) couplés pour recevoir le signal de courant du convertisseur tension-courant (13) afin de générer un signal de tension logarithmique dans les moyens à diodes (D1, D2);
un premier comparateur (21) pour comparer le signal de tension logarithmique à une tension de référence et produire un premier signal de comparaison, caractérisé en ce que le circuit de détection comprend en outre :
un moyen de détection de crête (27) pour détecter le signal de tension logarithmique dans lesdits moyens à diodes (D1, D2) et générer un signal de tension de crête proportionnel à la valeur de crête du signal de tension logarithmique;
un second comparateur (23) ayant des entrées connectées pour recevoir le signal de tension de crête et le signal de tension logarithmique pour comparer le signal de tension de crête au signal de tension logarithmique et produire un second signal de comparaison;
un moyen de décalage (29) pour délivrer une tension de décalage à l'une des entrées du second comparateur (23); et
une bascule bistable (25) ayant des entrées de réglage et de remise à zéro pour recevoir le premier signal de comparaison et le second signal de comparaison et une sortie pour la production d'un signal de sortie.

2. Circuit de détection selon la revendication 1, dans lequel la tension de décalage produite par le moyen de décalage comprend un composant de tension qui est proportionnel à la température absolue.

3. Circuit de détection selon la revendication 2, dans lequel le moyen de décalage comprend une paire de transistors différentiels bipolaires (Ql, Q2) avec des transistors proportionnés, les bases de la paire de transistors (Q1, Q2) formant les entrées du second comparateur (23).

4. Circuit de détection selon la revendication 1, 2 ou 3, dans lequel le moyen de détection de crête (27) comprend un condensateur (Cl) pour maintenir le signal de tension de crête et un moyen (51) pour décharger le condensateur de maintien (C1) en réponse au signal de sortie de la bascule bistable.

5. Circuit de détection selon la revendication 1, 2, 3 ou 4, dans lequel les moyens à diodes comprennent au moins deux diodes à direction égale (D1a, Dlb) connectées en série l'une avec à l'autre et une autre diode à direction opposée (D2) disposée parallèle par rapport auxdites au moins deux diodes à direction égale (D1a, D1b).

6. Circuit de détection selon la revendication 1, 2, 3, 4 ou 5, comprenant en outre :
une source de courant de référence (IR4) pour acheminer un courant de référence;
une diode de référence (D4) couplée pour recevoir le courant de référence de la source de courant de référence (IR4) afin de générer un signal de tension de référence aux bornes de la diode de référence (D4); et
des moyens (55, 61) pour soustraire le signal de tension de référence du signal de tension logarithmique.

7. Circuit de détection selon la revendication 6, comprenant en outre une résistance (R4) et une source de courant fonction de la température (IR5) pour acheminer un courant proportionnel à la température absolue à travers la résistance (R4), la tension aux bornes de la résistance (R4) étant couplée à l'une des entrées du second comparateur (23).

8. Circuit de détection selon la revendication 7, dans lequel la résistance (R4) est connectée entre la source de courant fonction de la température (IR5) et une sortie du moyen (61) de soustraction.

9. Circuit de détection selon la revendication 1, 2, 3, 4, 5, 6, 7 ou 8, dans lequel le convertisseur tension-courant (13) est un convertisseur tension-courant différentiel (13, 17, 19) ayant une entrée différentielle pour recevoir la tension d'entrée.

10. Circuit de détection selon la revendication 9, dans lequel le convertisseur différentiel tension-courant (13, 17, 19) comprend :
une première résistance de conversion (R2) et une seconde résistance de conversion (R3);
un premier amplificateur (33) ayant une entrée inverseuse, une entrée non inverseuse et deux sorties (39a, 37a) sensiblement également sensibles à une différence de tension entre les entrées inverseuse et non inverseuse du premier amplificateur, l'une (39a) des deux sorties du premier amplificateur (33) étant couplée à l'entrée inverseuse du premier amplificateur (33) et à la première résistance de conversion (R2), l'autre (37a) des deux sorties du premier amplificateur (33) étant couplée aux moyens à diodes (D1, D2);
un second amplificateur (35) ayant une entrée inverseuse, une entrée non inverseuse et deux sorties (39a, 37a) sensiblement également sensibles à une différence de tension entre les entrées inverseuse et non inverseuse du second amplificateur (35), l'une (39b) des deux sorties du second amplificateur (35) étant couplée à l'entrée inverseuse du second amplificateur (35) et à la seconde résistance de conversion (R3), l'autre (37b) des deux sorties du second amplificateur (35) étant couplée à ladite une sortie (39a) du premier amplificateur (33) qui est couplée à l'entrée inverseuse du premier amplificateur (33).
